# EUROPÄISCHE PATENTSCHRIFT

(11) **EP 2 057 696 B1**
(45) Veröffentlichungstag und Bekanntmachung des Hinweises auf die Patenterteilung: **07.10.2015**
(21) Anmeldenummer: 08706745.0
(22) Anmeldetag: 11.01.2008
(51) Int. Cl.: H01L 33/00, H01L 33/38

(54) **OPTOELEKTRONISCHER HALBLEITERCHIP UND VERFAHREN ZUR DESSEN HERSTELLUNG**
OPTOELECTRONIC SEMICONDUCTOR CHIP AND METHOD FOR MANUFACTURING THE SAME
PUCE DE SEMICONDUCTEUR OPTOÉLECTRONIQUE ET PROCÉDÉ DE SA FABRICATION

(30) Priorität: 31.01.2007 DE 102007005672; 30.04.2007 DE 102007020291
(43) Veröffentlichungstag der Anmeldung: 13.05.2009
(73) Patentinhaber: OSRAM Opto Semiconductors GmbH, 93055 Regensburg (DE)
(72) Erfinder: WINDISCH, Reiner, 93186 Pettendorf (DE)
(74) Vertreter: Epping - Hermann - Fischer
(86) Internationale Anmeldenummer: PCT/DE2008/000044
(87) Internationale Veröffentlichungsnummer: WO 2008/092417

(56) Entgegenhaltungen:
- WO-A-2005/117147
- WO-A-2007/124708
- JP-A- 2001 189 493
- US-A- 5 789 768
- US-A1- 2004 104 390
- US-A1- 2004 124 428
- US-A1- 2004 135 166
- US-A1- 2004 178 415
- US-A1- 2007 012 937

## Beschreibung

Diese Patentanmeldung beansprucht die Priorität der deutschen Patentanmeldungen 10 2007 005 672.0 und 10 2007 020 291.3.

Optoelektronische Halbleiterchips aufweisend eine Kontaktstruktur und Verfahren zu dessen Herstellung sind beispielsweise aus den Druckschriften JP 2001/189493, US 2004/135166 und WO 2007/124708 bekannt.

Die vorliegende Erfindung betrifft einen strahlungserzeugenden Halbleiterchip, z. B. einen Lumineszenzdiodenchip.

Eine Aufgabe der Erfindung ist es, einen Halbleiterchip mit erhöhter Effizienz sowie ein Herstellungsverfahren anzugeben, das für die Herstellung derartiger Halbleiterchips geeignet ist.

Diese Aufgabe wird durch einen Halbleiterchip beziehungsweise ein Verfahren gemäß den unabhängigen Patentansprüchen 1 bzw. 11 gelöst.

Mit Vorteil kann über eine Kontaktschicht, die sowohl an den Halbleiterkörper als auch an eine auf den Halbleiterkörper aufgebrachte, strukturierte Anschlussschicht angrenzt, die Ladungsträgerinjektion in den Halbleiterkörper auf die Bereiche des Hälbleiterkörpers konzentriert werden, die mit der Anschlussschicht belegt sind. In einem von der Anschlussschicht freien Bereich des Halbleiterkörpers, in dem die Kontaktschicht an den Halbleiterkörper angrenzt, kann eine Ladungsträgerinjektion gegenüber den mit der Anschlussschicht bedeckten Bereichen vermindert werden. Dementsprechend gelangen von den Bereichen aus, in denen die Kontaktschicht unmittelbar an den Halbleiterkörper angrenzt, nur vermindert Ladungsträger in den aktiven Bereich, wodurch in diesen Bereichen des aktiven Bereichs nur eine vergleichsweise geringe Strahlungsleistung erzeugt wird.

Der Anschlussbereich einer auf der von der Kontaktschicht abgewandten Seite des Halbleiterkörpers angeordneten Elektrode, z. B. der Bereich der Elektrode, der zur Verbindung mit einem Bonddraht vorgesehen ist, ist für die im aktiven Bereich erzeugte Strahlung oftmals stark absorbierend. Daher ist es von Vorteil eine Ladungsträgerinjektion in den Halbleiterkörper von der der Elektrode abgewandten Seite in dem vom Anschlussbereich überdeckten Bereich gezielt zu mindern. Dies kann über eine in diesem Bereich ausgesparte strukturierte Anschlussschicht erzielt werden. Die unterhalb des Anschlussbereichs erzeugte Strahlungsleistung und hierüber die in dem Anschlussbereich absorbierbare Strahlungsleistung werden so vermindert.

Weitere vorteilhafte Ausführungsformen für einen optoelektronischen Halbleiterchip und für ein Verfahren zur Herstellung einer Kontaktstruktur für einen zur Strahlungserzeugung geeigneten optoelektronischen Halbleiterchip sind Gegenstand der abhängigen Patentansprüche.

Es wird ein optoelektronischer Halbleiterchip angegeben, mit einem Halbleiterkörper, der eine Halbleiterschichtenfolge mit einem zur Strahlungserzeugung geeigneten aktiven Bereich aufweist, umfassend:
eine auf dem Halbleiterkörper angeordnete und elektrisch leitend mit dem aktiven Bereich verbundene strahlungsdurchlässige und elektrisch leitfähige Kontaktschicht, wobei die Kontaktschicht an eine Barriereschicht der Halbleiterschichtenfolge und an eine auf dem Halbleiterkörper aufgebrachte und eine Struktur aufweisende Anschlussschicht angrenzt;
eine auf einer von der Barriereschicht abgewandten Seite des aktiven Bereichs auf dem Halbleiterkörper angeordnete Elektrode, die einen Anschlussbereich aufweist, wobei die Kontaktschicht in einem von dem Anschlussbereich der Elektrode überdeckten Bereich der Barriereschicht ganzflächig an die Barriereschicht angrenzt.

Es wird weiter ein optoelektronischer Halbleiterchip angegeben, bei dem die Anschlussschicht eine Aussparung in dem von dem Anschlussbereich der Elektrode überdeckten Bereich aufweist und sich die Kontaktschicht durch die Aussparung erstreckt.

Es wird weiter ein optoelektronischer Halbleiterchip angegeben, bei dem die Anschlussschicht an die Barriereschicht angrenzt.

Erfindungsgemäß ist weiter ein optoelektronischer Halbleiterchip angegeben, bei dem eine Struktur aufweisende Zwischenschicht der Halbleiterschichtenfolge zwischen der Anschlussschicht und der Barriereschicht angeordnet ist, wobei die Zwischenschicht in dem von der Elektrode überdeckten Bereich eine Aussparung aufweist und sich die Kontaktschicht durch die Aussparung der Zwischenschicht erstreckt.

Es wird weiter ein optoelektronischer Halbleiterchip angegeben, bei dem die Kontaktschicht als kontinuierliche Schicht ausgebildet ist.

Es wird weiter ein optoelektronischer Halbleiterchip angegeben, bei dem die Barriereschicht als kontinuierliche Schicht ausgebildet ist.

Es wird weiter ein optoelektronischer Halbleiterchip angegeben, bei dem der Halbleiterkörper eine Ausnehmung aufweist, die sich in Richtung des aktiven Bereichs verjüngt, wobei sich die Kontaktschicht in die Ausnehmung hinein erstreckt.

Es wird weiter ein optoelektronischer Halbleiterchip angegeben, bei dem die Anschlussschicht ein strahlungsdurchlässiges und elektrisch leitfähiges Oxid enthält.

Es wird weiter ein optoelektronischer Halbleiterchip angegeben, bei dem das elektrisch leitfähige Oxid der Anschlussschicht ein Metalloxid ist.

Es wird weiter ein optoelektronischer Halbleiterchip angegeben, bei dem das Metalloxid Zinkoxid, Zinnoxid oder Indiumzinnoxid umfasst.

Es wird weiter ein optoelektronischer Halbleiterchip angegeben, bei dem die Anschlussschicht als Anschlussmetallisierung oder Anschlusslegierung ausgebildet ist.

Es wird weiter ein optoelektronischer Halbleiterchip angegeben, bei dem die Anschlussschicht AuGe oder AuZn umfasst.

Es wird weiter ein optoelektronischer Halbleiterchip angegeben, bei dem die Kontaktschicht ein strahlungsdurchlässiges und elektrisch leitfähiges Oxid, insbesondere ein Metalloxid, zum Beispiel ein Zinkoxid, ein Zinnoxid oder ein Indiumzinnoxid, enthält.

Es wird weiter ein optoelektronischer Halbleiterchip angegeben, bei dem auf der von dem aktiven Bereich abgewandten Seite der Kontaktschicht eine Spiegelschicht angeordnet ist.

Es wird weiter ein optoelektronischer Halbleiterchip angegeben, bei dem die Spiegelschicht ein Metall enthält.

Es wird weiter ein optoelektronischer Halbleiterchip angegeben, bei dem die Spiegelschicht Au, Ag oder Al enthält.

Es wird weiter ein optoelektronischer Halbleiterchip angegeben, bei dem die Barriereschicht zwischen dem aktiven Bereich und der Anschlussschicht angeordnet ist.

Es wird weiter ein optoelektronischer Halbleiterchip angegeben, bei dem der Halbleiterkörper als DünnfilmHalbleiterkörper ausgeführt ist.

Es wird weiter ein optoelektronischer Halbleiterchip angegeben, bei dem der Halbleiterchip einen Träger umfasst, auf dem die Halbleiterschichtenfolge angeordnet ist, und die Kontaktschicht zwischen der Halbleiterschichtenfolge und dem Träger angeordnet ist.

Es wird weiter ein optoelektronischer Halbleiterchip angegeben, bei dem die Spiegelschicht zwischen der Kontaktschicht und dem Träger angeordnet ist.

Es wird weiter ein optoelektronischer Halbleiterchip angegeben, bei dem ein elektrischer Kontaktwiderstand der Kontaktschicht zur Anschlussschicht kleiner ist als ein elektrischer Kontaktwiderstand der Kontaktschicht zur Barriereschicht.

Es wird weiter ein Verfahren zur Herstellung eines zur Strahlungserzeugung geeigneten optoelektronischen Halbleiterchips angegeben, umfassend die Schritte:
- Bereitstellen eines Halbleiterkörpers, der eine Halbleiterschichtenfolge mit einer Barriereschicht und einem zur Strahlungserzeugung geeigneten aktiven Bereich aufweist,
- Ausbilden einer Zwischenschicht (20) auf der Barriereschicht (5),- Ausbilden einer Anschlussschicht auf der zwischenschicht,
- Entfernen von Bereichen der Anschlussschicht und der Zwischenschicht zur Herstellung einer strukturierten Anschlussschieht und Zwischenschicht,
- Aufbringen einer strahlungsdurchlässigen und elektrisch leitfähigen Kontaktschicht auf den Halbleiterkörper derart, dass die Kontaktschicht an die Anschlussschicht angrenzt und in einem von einem Anschlussbereich einer vorgesehenen Elektrode überdeckten Bereich vollflächig an die Barriereschicht angrenzt,
- Aufbringen der Elektrode auf den Halbleiterkörper, wobei die Elektrode den Anschlussbereich aufweist und die Elektrode auf der von der Barriereschicht abgewandten Seite des aktiven Bereichs angeordnet ist und wobei die Struktur der Anschlussschicht, der Zwischenschicht und die Elektrode derart aufeinander abgestimmt sind, dass die Anschlussschicht und die Zwischenschicht in einem von dem Anschlussbereich der Elektrode überdeckten Bereich vollflächig ausgespart sind, wobei sich die Kontaktschicht durch die Aussparung der Zwischenschicht erstreckt.

Es wird weiter ein Verfahren angegeben, bei dem das Aufbringen der Kontaktschicht mittels Abscheidens, z. B. mittels eines Sputterprozesses, erfolgt.

Es wird weiter ein Verfahren angegeben, bei dem das Aufbringen der Kontaktschicht unmittelbar nach dem Ausbilden der strukturierten Anschlussschicht erfolgt.

Es wird weiter ein Verfahren angegeben, bei dem das Aufbringen der Anschlussschicht das Aufbringen einer strahlungsdurchlässigen und elektrisch leitfähigen Oxidschicht umfasst.

Es wird weiter ein Verfahren angegeben, bei dem die elektrisch leitfähige Oxidschicht eine Metalloxidschicht umfasst.

Es wird weiter ein Verfahren angegeben, bei dem die Metalloxidschicht eine Zinkoxidschicht, eine Zinnoxidschicht oder eine Indiumzinnoxidschicht umfasst.

Es wird weiter ein Verfahren angegeben, bei dem das Aufbringen der Anschlussschicht das Aufbringen einer metallhaltigen Anschlussschicht umfasst.

Es wird weiter ein Verfahren angegeben, bei dem die Anschlussschicht AuGe oder AuZn umfasst.

Es wird weiter ein Verfahren angegeben, bei dem auf die von der Anschlussschicht abgewandte Seite der Kontaktschicht eine Spiegelschicht aufgebracht wird.

Es wird weiter ein Verfahren angegeben, bei dem vor dem Aufbringen der Kontaktschicht eine Ausnehmung im Halbleiterkörper ausgebildet wird, die sich in Richtung der von der Kontaktschicht abgewandten Seite des Halbleiterkörpers verjüngt.

Es wird weiter ein Verfahren angegeben, bei dem ein Kontaktwiderstand der Kontaktschicht zur strukturierten Anschlussschicht kleiner ist als ein Kontaktwiderstand der Kontaktschicht zum Halbleiterkörper in dem von dem Anschlussbereich der Elektrode überdeckten Bereich.

Ausführungsformen für einen optoelektronischen Halbleiterchip und für ein Verfahren zur Herstellung einer Kontaktstruktur für einen zur Strahlungserzeugung geeigneten optoelektronischen Halbleiterchip sollen im Folgenden unter Bezugnahme auf die Figuren näher erläutert werden. Darin zeigen:
Figur 1 eine schematische Querschnittsansicht eines nicht erfindungsgemäßen optoelektronischen Halbleiterchips,
Figur 2 eine schematische Querschnittsansicht einer Ausführungsform eines erfindungsgemäßen optoelektronischen Halbleiterchips,
Figur 3 eine schematische Querschnittsansicht einer eines nicht erfindungsgemäßen opetoelektromischen Halbleiterchips,
Figur 4 in den Figuren 4A und 4B schematische Draufsichten auf die Oberseite bzw. die Unterseite eines Halbleiterkörpers einer Ausführungsform eines erfindungsgemäßen optoelektronischen Halbleiterchips,
Figur 5 in den Figuren 5A bis 5D ein nicht erfindungsgemäßes verfahren zur Herstellung einer Kontaktstruktur für einen zur Strahlungserzeugung geeigneten optoelektronischen Halbleiterchip und
Figur 6 in den Figuren 6A bis 6D ein Ausführungsbeispiel eines erfindungsgemäßen Verfahrens zur Herstellung einer Kontaktstruktur für einen zur Strahlungserzeugung geeigneten optoelektronischen Halbleiterchip.

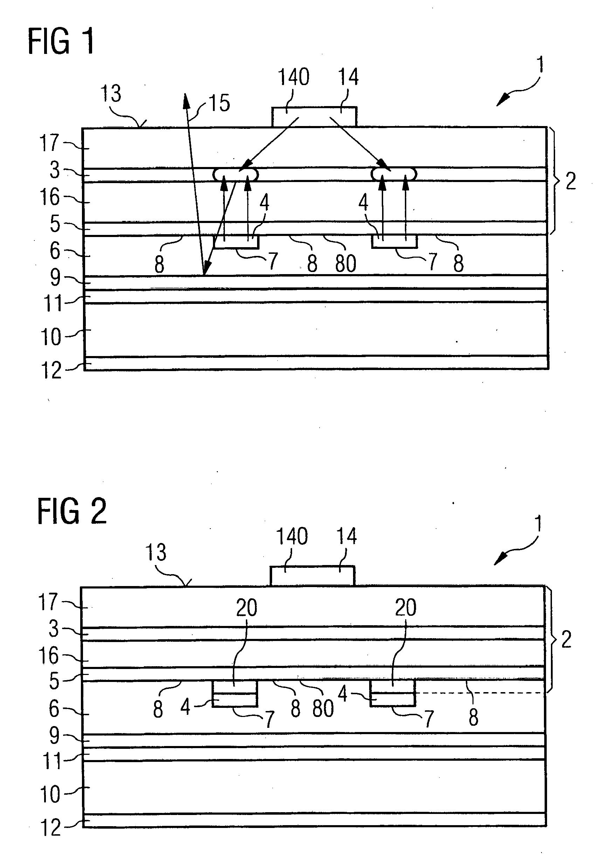

Die Figuren 1 und 2 zeigen jeweils schematische Querschnittsansichten eines optoelektronischen Halbleiterchips 1, z. B. eines LED-Chips.

Der Halbleiterchip 1 weist jeweils einen Halbleiterkörper 2 auf, der eine Halbleiterschichtenfolge mit einem zur Strahlungserzeugung geeigneten aktiven Bereich 3 umfasst. Die Halbleiterschichtenfolge, die vorzugsweise epitaktisch, zum Beispiel mittels MOVPE (Metal Organic Vapor Phase Epitaxy), auf einem Aufwachssubstrat (nicht explizit dargestellt) gewachsen ist, umfasst weiterhin eine Barriereschicht 5. In den in den Figuren 1 und 2 dargestellten Ausführungsformen des Halbleiterchips ist die Barriereschicht als kontinuierliche Schicht ausgebildet.

Auf dem Halbleiterkörper 2 ist eine strahlungsdurchlässige und elektrisch leitfähige Kontaktschicht 6 angeordnet, die sowohl an eine auf der Barriereschicht 5 angeordnete, auf den Halbleiterkörper 2 aufgebrachte und bereichsweise ausgesparte Anschlussschicht 4 als auch an die Barriereschicht 5 angrenzt. Die Anschlussschicht 4 kann beispielsweise mittels eines physikalischen Abscheideverfahrens, wie etwa eines Sputterprozesses aufgebracht werden.

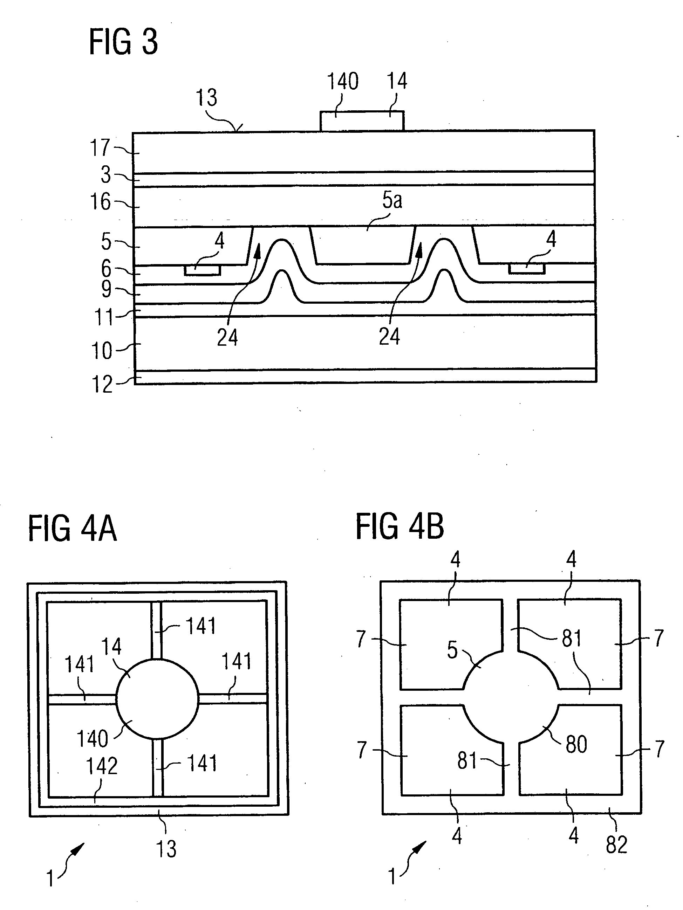

Eine Elektrode 14 ist auf einer der Barriereschicht 5 abgewandten Seite des aktiven Bereichs 3 auf dem Halbleiterkörper des Halbleiterchips 1 und insbesondere auf einer Oberseite 13 des Halbleiterkörpers 2 angeordnet. Wie in Figur 4A dargestellt, weist die Elektrode 14 einen Anschlussbereich 140 auf. Dieser ist bevorzugt zur elektrischen Verbindung mit einem Bonddraht vorgesehen und kann dementsprechend als Bondpad ausgebildet sein. Weiterhin kann die Elektrode mehrere, elektrisch leitend mit dem Anschlussbereich 140 verbundene Abschnitte 141 zur Erzielung einer Stromaufweitung vom Anschlussbereich ausgehend über die Oberseite 13 des Halbleiterkörpers aufweisen (in den Figuren 1 und 2 nicht explizit dargestellt, vergleiche hierzu Figur 4). Über den Anschlussbereich kann der Halbleiterchip 1 mit einem externen Anschlussleiter, z. B. einem Leiterrahmen oder einer Leiterplatte, elektrisch leitend verbunden werden. Die Elektrode 14 kann als Metallisierung ausgeführt sein.

Im direkten mechanischen Kontaktbereich der Kontaktschicht zur Anschlussschicht ist ein elektrischer Kontaktbereich 7 ausgebildet, über den die Kontaktschicht 6 mit dem aktiven Bereich 3 elektrisch leitend verbunden ist. Im direkten mechanisch Kontaktbereich der Kontaktschicht 6 zur Barriereschicht 5 ist ein elektrischer Barrierebereich 8 ausgebildet.

Eine Injektion von Ladungsträgern in den Halbleiterkörper 2 über den elektrischen Barrierebereich 8 ist gegenüber einer Injektion von Ladungsträgern in den Halbleiterkörper über den elektrischen Kontaktbereich 7 erschwert. Insbesondere sind die Materialien der Kontaktschicht, der Anschlussschicht und der Barriereschicht zweckmäßigerweise derart ausgewählt, dass ein elektrischer Kontaktwiderstand der Kontaktschicht 6 zur Anschlussschicht 4 kleiner ist als ein elektrischer Kontaktwiderstand der Kontaktschicht 6 zur Barriereschicht 5. Bevorzugt weist der elektrische Kontaktwiderstand der Kontaktschicht 6 zur Anschlussschicht 4 ein ohmsches Verhalten auf, während der elektrische Kontaktwiderstand der Kontaktschicht 6 zur Barriereschicht 5 ein nicht-ohmsches Verhalten aufweist. Der elektrische Kontaktbereich 7 und der Barrierebereich 8 sind bezüglich der Kontaktschicht 6 parallel geschaltet. Daher werden über den Barrierebereich 8 erheblich weniger Ladungsträger in den Halbleiterkörper injiziert als über den Kontaktbereich 7.

Es sei noch angemerkt, dass die Barriereschicht 5 keine gesondert im Halbleiterkörper vorgesehene Schicht sein muss, sondern vielmehr auch in der Halbleiterschicht 16 integriert sein kann. Insbesondere kann zum Beispiel ein der Kontaktschicht zugewandter Bereich der Halbleiterschicht 16 als Barriereschicht dienen.

Um einen großen Kontaktwiderstand der Kontaktschicht 6 zur Barriereschicht 5 zu erzielen, kann eine Dotierstoffkonzentration der Barriereschicht vorteilhaft gering gewählt werden. Beispielsweise kann die Dotierstoffkonzentration in der Barriereschicht hierfür 1*10¹⁸ 1/(cm³) oder weniger betragen, z. B. für eine p-leitende Barriereschicht, die bevorzugt mit Mg oder C dotiert ist, oder für eine n-leitende Barriereschicht, die bevorzugt mit Si oder Te dotiert ist.

Eine derart geringe Dotierung kann für einen erhöhten Kontaktwiderstand der Kontaktschicht 6 zur Barriereschicht 5 gegenüber dem Kontaktwiderstand der Kontaktschicht 6 zur Anschlussschicht 4 bereits ausreichend sein. Die Leitfähigkeit im Halbleiterkörper 2 in Richtung des aktiven Bereichs 3 wird durch eine derart geringe Dotierung der Barriereschicht 5 mit Vorteil nicht nennenswert gemindert.

Durch gezielte Ausbildung eines oder einer Mehrzahl von elektrischen Kontakt- und Barrierebereichen 7 bzw. 8 kann somit mittels einer kontinuierlichen Kontaktschicht - sogar trotz einer elektrisch leitfähigen Kontaktschicht 6 - eine gezielte bereichsweise Strominjektion, also eine inhomogene Strominjektion, in den Halbleiterkörper 2 erzielt werden. Die bereichsweise Ladungsträgerinjektion kann über unterschiedliche Kontaktwiderstände der Kontaktschicht zur Anschlussschicht einerseits und zum Halbleiterkörper andererseits erzielt werden. Zur gezielten bereichsweisen Strominjektion in den Halbleiterkörper ist insbesondere keine zwischen dem Halbleiterkörper 2 und der Kontaktschicht 6 angeordnete dielektrische Schicht, die für eine elektrische Kontaktbildung der Kontaktschicht zum Halbleiterkörper Aussparungen umfasst, die mit einem elektrisch leitfähigen Material, das die elektrische Verbindung zwischen der Spiegelschicht und dem Halbleiterkörper herstellt, gefüllt sein können, erforderlich.

Auf einer dem Halbleiterkörper 2 abgewandten Seite der Kontaktschicht 6 ist eine elektrisch leitfähige Spiegelschicht 9 angeordnet, die bevorzugt als kontinuierliche Schicht ausgebildet ist. Die Spiegelschicht 9 ist bevorzugt vollflächig elektrisch leitend mit der Kontaktschicht 6 verbunden. Viele Metalle, darunter Ag, haften deutlich besser auf einigen strahlungsdurchlässigen elektrisch leitfähigen Oxidmaterialien, aus denen die Kontaktschicht 6 hergestellt ist, als auf einer Dielektrikumsschicht, wie etwa SiN oder SiO₂, so dass mit der erfindungsgemäßen Kontaktschicht 6 die Verwendung reiner Spiegelmetalle ohne Beimischungen oder (haftvermittelnde) Zwischenschichten vereinfacht wird.

Zur Vermeidung eines direkten Kontakts zwischen dem Halbleitermaterial des Halbleiterkörpers 2 und der Spiegelschicht 9 ist die Kontaktschicht 6 bevorzugt durchgehend zwischen der Spiegelschicht 9 und dem Halbleiterkörper 2 angeordnet. Dadurch kann der Bildung einer reflektivitätsmindernden Legierung aus dem Material der Spiegelschicht und dem Halbleitermaterial vorgebeugt werden. Die Spiegelschicht kann also über ihren gesamten lateralen Verlauf im Wesentlichen eine gleich bleibend hohe Reflektivität aufweisen.

Der Halbleiterkörper 2 ist bevorzugt als Dünnfilmhalbleiterkörper ausgeführt, bei dem ein Aufwachssubstrat für die Halbleiterschichtenfolge von der Halbleiterschichtenfolge bereichsweise (nicht dargestellt) oder vollständig entfernt ist.

Um die mechanische Stabilität des Dünnfilmhalbleiterkörpers 2 zu erhöhen, ist dieser zweckmäßigerweise auf einem Träger 10 angeordnet, welcher vom Aufwachssubstrat der Halbleiterschichtenfolge verschieden ist. Somit ist der Halbleiterchip 1 als Dünnfilmhalbleiterchip ausgebildet. Der Dünnfilmhalbleiterchip umfasst den Dünnfilmhalbleiterkörper und den Träger.

Zur Befestigung des Dünnfilmhalbleiterkörpers 2 auf dem Träger 10 ist zwischen der Spiegelschicht 9 und dem Träger 10 eine Verbindungsschicht 11 angeordnet. Bevorzugt sind die Verbindungsschicht 11 und/oder der Träger 10 elektrisch leitfähig ausgebildet, sodass eine elektrische Kontaktierung des Halbleiterchips 1 durch den Träger 10, die Verbindungsschicht 11, die Spiegelschicht 9 und die Kontaktschicht 6 erfolgen kann.

Auf einer der Kontaktschicht 6 abgewandten Seite des Trägers 10 ist eine Montageelektrode 12 angeordnet, mittels derer der Halbleiterchip auf einem externen Anschlussleiter, beispielsweise einem Anschlussleiter eines oberflächenmontierbaren Bauelements oder dem Anschlussleiter einer Leiterplatte angeordnet, befestigt und elektrisch leitend mit diesem verbunden und werden kann. Die Montageelektrode 12 kann als Metallisierung ausgeführt sein.

Bei Betrieb des Halbleiterchips 1 werden durch Anlegen geeigneter Spannungen an die Elektrode 14 und an die Montageelektrode 12 Ladungsträger in den aktiven Bereich 3 injiziert, welche dort unter Emission von Strahlung rekombinieren können. In den Figuren 1 und 2 sind jeweils Pfeile angegeben, die die über die Elektrode 14 und die Anschlussschicht 4 in den Halbleiterkörper 2 injizierten Ladungsträger andeuten.

Durch die Ausgestaltung und die Anordnung der jeweiligen in den Figuren 1 und 2 gezeigten elektrischen Kontaktbereiche 7 kann die Strahlungserzeugung in dem aktiven Bereich 3 auf bevorzugte Bereiche konzentriert werden. Strahlung, die in Zonen des aktiven Bereichs 3, die in vertikaler Richtung vom aktiven Bereich aus gesehen von der Elektrode 14 überdeckt werden, erzeugt wird, wird mit erhöhter Wahrscheinlichkeit von der Elektrode 14 absorbiert. Der Anschlussbereich 140 ist insbesondere für eine Drahtbondverbindung in der Regel vergleichsweise dick auszuführen. Daher kann im Anschlussbereich ein nicht unerheblicher Anteil an Strahlungsleistung absorbiert werden.

Die jeweiligen elektrischen Kontaktbereiche 7 sind daher in lateraler Richtung von dem Anschlussbereich 140 der Elektrode 14 beabstandet angeordnet. Hierzu weist die strukturierte Anschlussschicht 4 in einem von dem Anschlussbereich 140 der Elektrode 14 überdeckten Bereich eine Aussparung auf. Die Kontaktschicht 6 grenzt insbesondere ganzflächig an einen Bereich der Barriereschicht 5 in dem Barrierebereich 80 an, der von dem Anschlussbereich 140 der Elektrode 14 überdeckt wird. Bevorzugt überdeckt der Barrierebereich 80 den Anschlussbereich 140 der Elektrode 14 vollständig.

Im Unterschied zu dem in Figur 1 dargestellten nicht erfindungsgemäßen Halbleiterchip ist bei dem in Figure 2 dargestellten erfindungsgemäßen Halbleiterchip eine Zwischenschicht 20 des Halbleiterkörpers 2, die eine Struktur aufweist, zwischen der strukturierten Anschlussschicht 4 und der Barriereschicht 5 angeordnet. Mittels der strukturierten Zwischenschicht kann die elektrische Kontaktbildung zwischen Anschlussschicht und Halbleiterkörper unabhängig von den Barriereeigenschaften der Barriereschicht optimiert werden. Die Kontaktschicht erstreckt sich durch die, vorzugsweise entsprechend der Anschlussschicht strukturierten und ausgesparte, Zwischenschicht hindurch. Der elektrische Kontaktwiderstand zwischen der Anschlussschicht 4 und der Zwischenschicht 20 ist zweckmäßigerweise kleiner als der elektrische Kontaktwiderstand zwischen der Kontaktschicht 6 und der Barriereschicht 5.

Die Zwischenschicht 20 weist zweckmäßigerweise eine höhere Dotierstoffkonzentration auf als die Barriereschicht 5. Das Ausbilden eines elektrischen Kontaktwiderstandes zwischen der Anschlussschicht 4 und der Zwischenschicht 20, der kleiner als der elektrische Kontaktwiderstand zwischen der Barriereschicht und der Kontaktschicht ist, kann so erleichtert werden. Die Zwischenschicht 20 kann hierzu beispielsweise eine Dotierstoffkonzentration von 1*10¹⁹ 1/(cm³) oder mehr, bevorzugt 1*10²⁰ 1/(cm³) oder mehr, besonders bevorzugt 1*10²¹ 1/(cm³) oder mehr aufweisen. Die Zwischenschicht 20 weist zweckmäßigerweise den gleichen Leitungstyp wie die Halbleiterschicht 16 bzw. die Barriereschicht 5 auf.

Zur weitergehenden Vermeidung einer Strahlungserzeugung im aktiven Bereich 3 unterhalb des Anschlussbereichs 140 der Elektrode 14 ist der Barrierebereich 8 bevorzugt in einem (Teil-) Bereich, der sich mit dem Anschlussbereich 140 der Elektrode 14 gegenseitig überdeckt, gegenüber der lateralen Ausdehnung des Anschlussbereichs 140 lateral verbreitert. Infolge der Anordnung der jeweiligen Kontaktbereiche 7 ist bei Betrieb des Halbleiterchips 1 die Strahlungserzeugung auf nicht von dem Anschlussbereich 140 der Elektrode 14 überdeckte Bereiche des aktiven Bereichs 3 konzentriert - vergleiche die in der Figur 1 umgrenzten Gebiete, in denen über die Elektrode 14 und den jeweiligen elektrischen Kontaktbereich 7 in den Halbleiterkörper injizierte Ladungsträger unter Strahlungserzeugung rekombinieren. Diese Rekombinationsgebiete sind von der Elektrode 14 lateral beabstandet.

Eine im aktiven Bereich 3 erzeugte und in Richtung der Kontaktschicht 6 verlaufende Strahlung tritt durch die strahlungsdurchlässige Kontaktschicht 6 hindurch und trifft auf die Spiegelschicht 9 auf. Die auf die Spiegelschicht 9 auftreffende Strahlung wird mittels der Spiegelschicht 9 in den Halbleiterkörper 2 zurückreflektiert und über die der Spiegelschicht 9 abgewandte Oberseite 13 des Halbleiterkörpers 2 aus dem Halbleiterchip 1 ausgekoppelt. Anhand des Strahls 15 ist ein derartiger Strahlungsverlauf beispielhaft angedeutet. Durch die Reflexion der Strahlung an der Spiegelschicht 9 kann die Absorption von Strahlung in auf der dem aktiven Bereich 3 abgewandten Seite der Spiegelschicht angeordneten Elementen wie etwa der Verbindungsschicht 11 oder dem Träger 10 verringert werden. Außerdem kann die über die Oberseite 13 aus dem Halbleiterkörper austretende Strahlungsleistung erhöht werden.

Typischerweise können in einem lateralen Randbereich des Halbleiterkörpers und insbesondere des aktiven Bereichs 3 nichtstrahlende Rekombinationen von Ladungsträgern mit erhöhter Wahrscheinlichkeit erfolgen. Zur Verringerung der Ladungsträgerinjektion über die Kontaktfläche 6 in den Halbleiterkörper 2 in diesem Randbereich überdeckt der Barrierebereich 8 bevorzugt den Randbereich des aktiven Bereichs.

Der aktive Bereich 3 ist zwischen einer ersten Halbleiterschicht 16 und einer zweiten Halbleiterschicht 17 angeordnet, die unterschiedliche Leitungstypen aufweisen (n-leitend bzw. p-leitend). Die Halbleiterschichten 16 und 17 können jeweils mehrere Schichten umfassen von denen eine als Mantelschicht ausgebildet sein kann, die den Einschluss von Ladungsträgern im aktiven Bereich und somit die Konversionseffizienz des Halbleiterchips von elektrischer Leistung in Strahlungsleistung erhöht. Der Halbleiterkörper einschließlich des aktiven Bereichs 3, der Barriereschicht 5, der ersten Halbleiterschicht 16 und/oder der zweiten Halbleiterschicht 17 enthält bevorzugt ein III-V Halbleitermaterial. Die zweite Halbleiterschicht 17 kann beispielsweise eine p-dotierte oder n-dotierte Schicht, wie etwa eine InGaAlP-, InAlP-, InGaP-, GaAs- oder AlGaAs-Schicht, umfassen, wobei der Dotierstoff Kohlenstoff oder Magnesium für eine p-Dotierung bzw. Silizium oder Tellur für eine n-Dotierung umfassen kann. Die zweite Halbleiterschicht 17 kann beispielsweise derart ausgebildet sein, dass sich ein Strom, der über die Elektrode 14 eingeprägt wird, mit geringem Widerstand lateral in der zweiten Halbleiterschicht 17 ausbreiten kann. Die erste Halbleiterschicht 16 kann beispielsweise eine n-dotierte bzw. eine p-dotierte Schicht, wie etwa eine InGaAlP-, InAlP-, InGaP-, GaAs- oder AlGaAs-Schicht, umfassen. Die Barriereschicht kann eine n-dotierte oder p-dotierte Schicht, z. B. eine InGaAlP-, InAlP-, InGaP-, GaAs- oder AlGaAs-Schicht umfassen. Die Zwischenschicht 20 kann eine n-dotierte oder p-dotierte Schicht, z. B. eine GaP-, GaAs- oder AlGaAs-Schicht umfassen. AlGaAs ist für eine elektrische Kontaktbildung zwischen der Zwischenschicht 20 und der Anschlussschicht 4 besonders geeignet.

Bevorzugt ist der Halbleiterchip zur Erzeugung sichtbarer Strahlung ausgestaltet.

Die Anschlussschicht 4 ist bevorzugt als ein strahlungsdurchlässiges und elektrisch leitfähiges Oxid, beispielsweise ein Metalloxid wie etwa Zinkoxid, Zinnoxid oder Indiumzinnoxid ausgeführt. Die Anschlussschicht 4 kann aber auch als legierter Metallkontakt ausgeführt sein, der beispielsweise AuGe oder AuZn umfasst. Die Verwendung einer Anschlussschicht 4 aus einem strahlungsdurchlässigen und elektrisch leitfähigen Oxid ist gegenüber der Verwendung eines legierten Metallkontakts bevorzugt, da die Einlegierung des Metalls um einem ohmschen Kontakt zu der Barriereschicht herzustellen bewirkt, dass das einlegierte Metall eine Rauhigkeit aufweist.

Die Kontaktschicht 6 ist bevorzugt als strahlungsdurchlässiges und elektrisch leitfähiges Oxid, beispielsweise ein Metalloxid wie etwa Zinkoxid, Zinnoxid oder Indiumzinnoxid ausgebildet. Im Falle, dass sowohl die Anschlussschicht 4 als auch die Kontaktschicht 6 aus einem strahlungsdurchlässigen und elektrisch leitfähigen Oxid bestehen, werden diese in unterschiedlichen Prozessschritten hergestellt, um zu bewirken, dass ein elektrischer Kontaktwiderstand der Kontaktschicht 6 zur Barriereschicht kleiner ist als ein elektrischer Kontaktwiderstand der Kontaktschicht 6 zur Barriereschicht. Hierzu sind die Anschlussschicht 4 und die Kontaktschicht 6 bevorzugt unterschiedlich dotiert, z. B. können die Kontaktschicht 6 und die Anschlussschicht 4 eine unterschiedliche Dotierung aufweisen. Beispielsweise kann die Anschlussschicht 4 Al-Dotierstoffe aufweisen, während die Kontaktschicht Ga-Dotierstoffe aufweisen kann.

Der aktive Bereich kann beispielsweise ein Phosphitverbindungshalbleitermaterial, insbesondere InGaAlP, umfassen. Die Spiegelschicht 9 ist bevorzugt als Au-, Ag-, oder AuZn-Spiegelschicht ausgebildet. Derartige Spiegelschichten weisen eine besonders hohe Reflektivität für mit Phosphitverbindungshalbleitermaterialien erzeugbare Strahlung, insbesondere vom gelben bis in den roten Spektralbereich auf.

Der Träger 10 kann Germanium oder GaAs enthalten oder daraus bestehen. Die Verbindungsschicht 11 kann als Lotschicht, beispielsweise als AuSn-haltige Schicht, als elektrisch leitfähig ausgeführte Klebeschicht oder als mittels eines Waferbondingverfahrens ausgebildete Schicht ausgeführt sein. Der aktive Bereich 3 umfasst bevorzugt eine Doppelheterostruktur oder eine Ein- oder Mehrfachquantentopfstruktur, wodurch die Quanteneffizienz des aktiven Bereichs erhöht werden kann. Die Bezeichnung Quantentopfstruktur umfasst im Rahmen der Anmeldung jegliche Struktur, bei der Ladungsträger durch Einfluss ("confinement") eine Quantisierung ihrer Energiezustände erfahren oder erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte sowie jede Kombination dieser Strukturen.

Figur 4 zeigt schematische Aufsichten auf einen Halbleiterchip gemäß Figur 1 oder Figur 2. In Figur 1 ist eine Aufsicht auf die Oberseite 13 des Halbleiterkörpers 2 dargestellt und in Figur 2 ist eine Aufsicht auf die Anschlussschicht 4 und die Barriereschicht 5 dargestellt.

Die Elektrode 14 weist einen Anschlussbereich 140, der zum Anschluss der Elektrode an einen externen Anschlussleiter, beispielsweise über einen Bonddraht vorgesehen ist. Die Elektrode 14 weist des Weiteren einen leitfähigen Elektrodenrahmen 142 auf, der in einem Randbereich der Oberseite 13 angeordnet ist und über leitfähige Stege 141 mit dem Anschlussbereich 140 verbunden ist. Mittels dieser Ausbildung der Elektrode 14 kann eine laterale Stromaufweitung vom Elektrodenbereich 140 ausgehend erzielt werden. In den in Figur 1 und Figur 2 dargestellten Querschnittsansichten der jeweiligen Halbleiterchips sind der Elektrodenrahmen und die Elektrodenstege aus Gründen der Übersichtlichkeit nicht dargestellt.

Wie in Figur 4B dargestellt, ist die Ausgestaltung des Barrierebereichs 8 an die Ausgestaltung der in Figur 4A gezeigten Elektrode 14 angepasst.

Der Halbleiterchip 1 weist, wie in Figur 4B dargestellt, mehrere voneinander getrennt ausgebildete elektrische Kontaktbereiche 7 sowie einen zusammenhängenden Barrierebereich 8 auf, der entsprechend der in Figur 4A gezeigten Elektrode 4 ausgebildet ist. Der Barrierebereich 8 umfasst dementsprechend einen Bereich 80, der über Stege 81 mit einem Barriererahmen 82 verbunden ist. Bevorzugt weisen die den jeweiligen Abschnitten der Elektrode 14 entsprechenden Abschnitte des Barrierebereichs 8 eine größere laterale Ausdehnung als die entsprechenden Elektrodenabschnitte auf. Der Barrierebereich 8 ist bevorzugt derart ausgebildet, dass trotz der Stromaufweitung im Halbleiterkörper eine Strahlungserzeugung im aktiven Bereich unterhalb der Elektrodenstruktur weitgehend vermieden werden kann.

Figur 3 zeigt ein nicht erfindungsgemäßen optoelektronischen Halbleiterchip 1, der im Wesentlichen den in den Figuren 1 und 2 gezeigten Halbleiterchips entspricht. Im Unterschied zu den in den Figuren 1 und 2 gezeigten Ausführungsbeispielen eines Halbleiterchips weist der Halbleiterkörper und insbesondere die Barriereschicht 5 des in Figur 3 gezeigten Halbleiterchips eine oder mehrere Ausnehmungen 24 auf, die sich bevorzugt ausgehend von einer dem aktiven Bereich 3 abgewandten Oberfläche der Barriereschicht 5 in Richtung des aktiven Bereichs 3 verjüngen.

Die Kontaktschicht 6 ist konform auf der strukturierten Barriereschicht 5 ausgebildet und erstreckt sich in die Ausnehmung(en) 24 hinein. Die Spiegelschicht 9 ist konform auf der Kontaktschicht 6 ausgebildet und kann sich gegebenenfalls ebenfalls in die Ausnehmung(en) 24 hinein erstrecken.

Bevorzugt sind die Ausnehmung(en) 24 derart ausgebildet, dass ein Abschnitt 5a der strukturierten Barriereschicht 5 den Anschlussbereich 140 der Elektrode 14 vollständig überdeckt.

Mittels der sich in Richtung des aktiven Bereichs 3 verjüngenden Ausnehmung(en) und insbesondere der darin angeordneten Spiegelschicht 9 kann die Verteilung der Auftreffwinkel von an der Spiegelschicht reflektierter und auf die Oberseite treffender Strahlung gegenüber einer durchgehend ebenen Spiegelschicht breiter gestreut werden. Dadurch wird die Wahrscheinlichkeit, dass von der Spiegelschicht reflektierte Strahlung mit einem Winkel kleiner als einem Grenzwinkel der Totalreflexion auf die Oberseite 13 des Halbleiterkörpers 2 trifft und damit aus dem Halbleiterkörper auskoppeln kann erhöht. Dementsprechend kann ein Anteil von im Halbleiterkörper fortgesetzt totalreflektierter Strahlung durch die Ausnehmung(en) 24 reduziert werden, wodurch die Auskoppeleffizienz des Halbleiterchips erhöht wird.

Die Ausnehmungen 24 können beispielsweise eine Mikroprismenstruktur aufweisen und werden vorzugsweise durch einen geeigneten Ätzprozess erzeugt.

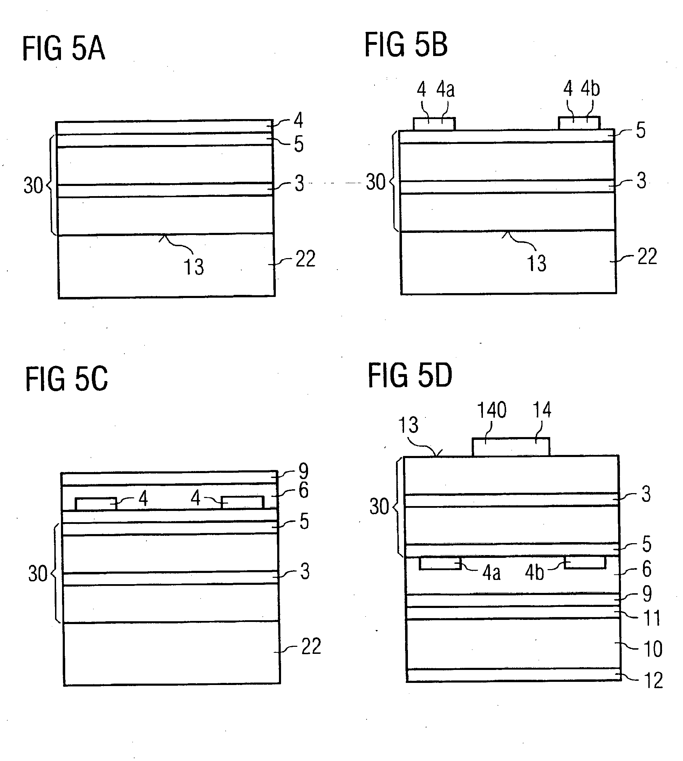

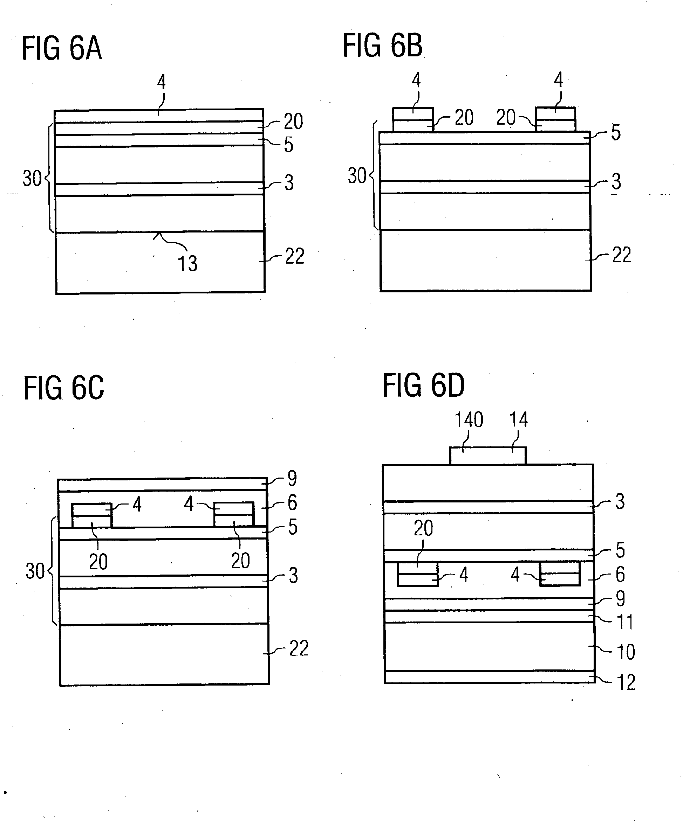

Die Figuren 5 und 6 zeigen in den Figuren 5A bis 5D beziehungsweise 6A bis 6D ein nicht erfindungsgemäßes Verfahren bzw. ein erfindungsgemäßes Verfahren zur Herstellung eines zur Strahlungserzeugung geeigneten optoelektronischen Halbleiterchips.

Mit Bezug auf Figur 5A und Figur 6A wird eine Halbleiterschichtenfolge 30 bereitgestellt, die eine Barriereschicht 5 sowie einen zur Strahlungserzeugung geeigneten aktiven Bereich 3 umfasst. Die Halbleiterschichtenfolge 30 ist auf einem Substrat 22 angeordnet. Das Substrat 22 ist vorzugsweise ein Aufwachssubstrat, auf dem die Halbleiterschichtenfolge 30 mit der monolithisch integrierten Barriereschicht, zum Beispiel mittels MOVPE, epitaktisch gewachsen wurde. Die Barriereschicht ist bevorzugt auf der dem Substrat 22 abgewandten Seite des aktiven Bereichs angeordnet.

Für eine Halbleiterschichtenfolge mit einem aktiven Bereich auf Phosphitverbindungshalbleitermaterialbasis eignet sich beispielsweise GaAs als Material für das Aufwachssubstrat.

Im Unterschied zu dem nicht erfindungsgemäßen Verfahren gemäß Figur 5 weist die Halbleiterschichtenfolge des Ausführungsbeispiels gemäß dem erfindungsgemäßen Verfahren gemäß Figur 6 eine weitere insbesondere die Zwischenschicht 20 auf, die gemäß Figur 6A den Halbleiterkörper abschließt und insbesondere auf der von dem aktiven Bereich abgewandten Seite der Barriereschicht 5 angeordnet ist.

Auf die dem Substrat 22 abgewandte Seite der Halbleiterschichtenfolge - gemäß dem nicht erfindungsgemäßen verfahren in Figur 5A auf die Barriereschicht 5 - gemäß dem Ausführungsbeispiel gemäß dem erfindungsgemäßen Verfahren in Figur 6A auf die Zwischenschicht 20, wird dann eine Anschlussschicht 4 aufgebracht. Gemäß einer Ausführungsform umfasst das Aufbringen der Anschlussschicht das Aufbringen einer strahlungsdurchlässigen und elektrisch leitfähigen Oxidschicht, beispielsweise einer Metalloxidschicht wie etwa eine Zinkoxidschicht, Zinnoxidschicht oder eine Indiumzinnoxidschicht. Bevorzugt weist die Anschlussschicht des Weiteren Dotierstoffe wie etwa Al auf, um einen geringen elektrischen Kontaktwiderstand der Anschlussschicht zur Barriereschicht zu gewährleisten. Gemäß einer anderen Ausführungsform kann das Aufbringen der Anschlussschicht 4 das Aufbringen einer metallischen Schicht umfassen.

Mit Bezug auf Figur 5B und Figur 6B wird daraufhin die Anschlussschicht bereichsweise entfernt, um eine strukturierte Anschlussschicht 4 auszubilden und Bereiche der Barriereschicht freizulegen. Bei dem Ausführungsbeispiel gemäß Figur 6 werden dazu neben Bereichen der Anschlussschicht auch Bereiche der Zwischenschicht 20 entfernt, die unterhalb den entsprechenden Bereichen der Anschlussschicht angeordnet sind. Die bereichsweise Entfernung der Anschlussschicht wird bevorzugt derart ausgeführt, dass einzelne, separate Anschlusselemente 4a, 4b der Anschlussschicht 4 gebildet werden, die voneinander beabstandet sind. Es werden bevorzugt Bereiche der Barriereschicht freigelegt, in denen im fertigen Halbleiterchip eine Strominjektion in den Halbleiterkörper des Chips unerwünscht ist. Mittels des bereichsweisen Entfernens der Anschlussschicht und gegebenenfalls der Zwischenschicht 20 werden somit die elektrischen Barrierebereiche und die elektrischen Kontaktbereiche für den Halbleiterchip definiert (vgl. Figuren 1 bis 4). Es werden insbesondere Bereiche der Barriereschicht freigelegt, die von einem Anschlussbereich 140 (nicht gezeigt) einer in einem späteren Schritt ausgebildeten Elektrode 14 (nicht gezeigt) auf einer Oberseite 13 der Halbleiterschichtenfolge überdeckt wird (als Oberseite bezeichnet, da diese Seite im fertigen Halbleiterchip die Oberseite darstellt, vgl. Figur 5D). Die Strukturierung der Anschlussschicht kann beispielsweise mittels eines Ätzverfahrens unter Einsatz einer geeignet strukturierten Ätzmaske erfolgen. Für die Strukturierung der Zwischenschicht 20 kann mit Vorteil die gleiche Maske eingesetzt werden.

Dann wird mit gleichzeitigem Bezug auf Figur 5C und 5D eine strahlungsdurchlässige und elektrisch leitfähige Kontaktschicht 6 auf die strukturierte Anschlussschicht und auf die Barriereschicht 5 aufgetragen. Die Kontaktschicht ist insbesondere für die im aktiven Bereich erzeugbare Strahlung durchlässig. Das Auftragen der strahlungsdurchlässigen und elektrisch leitfähige Kontaktschicht 6 kann das Auftragen einer strahlungsdurchlässigen und elektrisch leitfähigen Oxidschicht, insbesondere einer Metalloxidschicht, wie etwa einer Zinkoxid-, Zinnoxid-, oder einer Indiumzinnoxidschicht umfassen. Die Kontaktschicht kann des weiteren einen oder eine Mehrzahl von Dotierstoffen, z. B. Ga, umfassen.

Die Kontaktschicht wird dabei so auf die Barriereschicht 5 und auf die strukturierte Anschlussschicht 4 aufgetragen, dass ein elektrischer Kontaktwiderstand der Kontaktschicht 6 zur Anschlussschicht 4 kleiner ist als ein elektrischer Kontaktwiderstand der Kontaktschicht 6 zur Barrierenschicht 5.

Somit schließt die Kontaktschicht elektrisch im Wesentlichen nur an die Anschlussschicht und nicht an die Barriereschicht an. Daher kann die Kontaktschicht 6 vollflächig aufgebracht werden, wobei eine nachfolgende Strukturierung der Kontaktschicht nicht erforderlich ist. Vielmehr kann trotzdem eine lokale und somit inhomogene Strominjektion in die Halbleiterschichtenfolge erzielt werden.

Dazu wird die Kontaktschicht 6 bevorzugt mittels eines Verfahrens aufgetragen, bei der eine Oberfläche der Barriereschicht 5, auf die die Kontaktschicht aufgetragen wird, beschädigt wird. Ein geeignetes Verfahren, eine Beschädigung der Oberfläche der Barriereschicht zu bewirken ist beispielsweise ein physikalisches Abscheideverfahren wie etwa ein Sputterverfahren. Das Auftragen der Kontaktschicht 6 kann nach dem Strukturieren der Anschlussschicht 4 erfolgen, ohne dass dazwischen ein Reinigungsschritt, beispielsweise zur Entfernung eines natürlichen Oxids durchgeführt wird. Auch dies kann dazu führen, dass ein elektrischer Kontaktwiderstand der Kontaktschicht 6 zur Anschlussschicht 4 kleiner ist als ein elektrischer Kontaktwiderstand der Kontaktschicht 6 zur Barrierenschicht 5.

Daraufhin wird auf die Kontaktschicht 6 eine Spiegelschicht 9 aufgebracht, die vorzugsweise metallisch oder als metallhaltige Legierung ausgeführt ist. Die Spiegelschicht kann, zum Beispiel mittels Aufdampfen oder Sputtern, abgeschieden werden. Die Spiegelschicht kann beispielsweise Gold, Silber oder Aluminium enthalten. Aufgrund der durchgehend ausgeführten Kontaktschicht 6 wird ein direkter Kontakt zwischen der Spiegelschicht 9 und dem Halbleitermaterial der Halbleiterschichtenfolge verhindert, wodurch wiederum eine reflexionsmindernde Legierungsbildung zwischen der Spiegelschicht und dem Halbleitermaterial vermieden wird.

Mit gleichzeitigem Bezug auf Figur 5D und Figur 6D wird die Schichtstruktur dann auf der dem Substrat 22 abgewandten Seite der Spiegelschicht 9 mittels einer Verbindungsschicht 11 auf einem Träger 10 befestigt. Der Träger kann beispielsweise Ge oder GaAs enthalten. Bevorzugt ist die Verbindungsschicht 11 elektrisch leitfähig ausgebildet. Die Verbindungsschicht 11 kann als Lotschicht, elektrisch leitfähig ausgebildete Klebeschicht oder eine in einem Waferbondingverfahren ausgebildete Schicht ausgeführt sein. Anschließend wird das Substrat zumindest bereichsweise (nicht dargestellt) oder vollständig von der Halbleiterschichtenfolge 30 entfernt. Die Entfernung des Substrats kann beispielsweise mittels Ätzen oder eines Laserablöseverfahrens erfolgen.

Auf der Oberseite 13 der Halbleiterschichtenfolge 30 wird eine Elektrode 14 mit einem Anschlussbereich 140 aufgebracht. Der Anschlussbereich 140 der Elektrode 14 wird dabei auf dem dafür vorgesehenen Bereich derart angeordnet, dass die strukturierte Anschlussschicht 4 nicht von dem Anschlussbereich 140 überdeckt wird.

Ist die strukturierte Anschlussschicht derart ausgebildet worden, dass separate Anschlusselemente 4a, 4b ausgebildet wurden, so ist insbesondere der laterale Abstand zwischen den separaten Anschlusselementen 4a, 4b zweckmäßigerweise größer als eine laterale Ausdehnung des Anschlussbereichs 140 der Elektrode 14.

Auf einer der Halbleiterschichtenfolge 30 abgewandten Seite des Trägers 10 wird eine Montageelektrode 12, zum Beispiel eine Metallisierung, zur Montage des Halbleiterchips auf einem externen elektrischen Anschlussleiter aufgebracht.

Die Erfindung ist nicht durch die Beschreibung anhand der Ausführungsbeispiele beschränkt.

## Patentansprüche

1. Optoelektronischer Halbleiterchip (1) mit einem Halbleiterkörper (2), der eine Halbleiterschichtenfolge mit einem zur Strahlungserzeugung geeigneten aktiven Bereich (3) aufweist, umfassend:
- eine auf dem Halbleiterkörper (2) angeordnete und elektrisch leitend mit dem aktiven Bereich (3) verbundene strahlungsdurchlässige und elektrisch leitfähige Kontaktschicht (6), wobei die Kontaktschicht (6) an eine Barriereschicht (5) der Halbleiterschichtenfolge und an eine auf dem Halbleiterkörper (2) aufgebrachte und eine Struktur aufweisende Anschlussschicht (4) angrenzt;
- eine auf einer von der Barriereschicht (5) abgewandten Seite des aktiven Bereichs (3) auf dem Halbleiterkörper (2) angeordnete Elektrode (14), die einen Anschlussbereich (140) aufweist, wobei die Kontaktschicht (6) in einem von dem Anschlussbereich (140) der Elektrode (14) überdeckten Bereich der Barriereschicht (5) ganzflächig an die Barriereschicht angrenzt;
- eine eine Struktur aufweisende Zwischenschicht (20) der Halbleiterschichtenfolge zwischen der Anschlussschicht (4) und der Barriereschicht (5), die in dem von der Elektrode überdeckten Bereich eine Aussparung aufweist, wobei sich die Kontaktschicht (6) durch die Aussparung der Zwischenschicht (20) erstreckt.

2. Halbleiterchip nach Anspruch 1, bei dem die Anschlussschicht (4) ein strahlungsdurchlässiges und elektrisch leitfähiges Oxid enthält.

3. Halbleiterchip nach einem der vorhergehenden Ansprüche, bei dem die Kontaktschicht (6) ein strahlungsdurchlässiges und elektrisch leitfähiges Oxid, insbesondere ein Metalloxid, zum Beispiel ein Zinkoxid, ein Zinnoxid oder ein Indiumzinnoxid, enthält.

4. Halbleiterchip nach einem der vorhergehenden Ansprüche, bei dem auf der von dem aktiven Bereich (3) abgewandten Seite der Kontaktschicht (6) eine Spiegelschicht (9) angeordnet ist.

5. Halbleiterchip nach Anspruch 4, bei dem die Spiegelschicht (9) ein Metall, insbesondere Au, Ag oder Al enthält.

6. Halbleiterchip nach einem der vorhergehenden Ansprüche, bei dem die Barriereschicht (5) zwischen dem aktiven Bereich (3) und der Anschlussschicht (4) angeordnet ist.

7. Halbleiterchip nach einem der vorhergehenden Ansprüche, bei dem der Halbleiterkörper (2) als DünnfilmHalbleiterkörper ausgeführt ist.

8. Halbleiterchip nach einem der vorhergehenden Ansprüche, bei dem der Halbleiterchip (1) einen Träger (10) umfasst, auf dem die Halbleiterschichtenfolge (2) angeordnet ist, und die Kontaktschicht (6) zwischen der Halbleiterschichtenfolge und dem Träger (10) angeordnet ist.

9. Halbleiterchip nach den Ansprüchen 4 und 8, bei dem die Spiegelschicht zwischen der Kontaktschicht und dem Träger angeordnet ist.

10. Halbleiterchip nach einem der vorhergehenden Ansprüche, bei dem ein elektrischer Kontaktwiderstand der Kontaktschicht (6) zur Anschlussschicht (4) kleiner ist als ein elektrischer Kontaktwiderstand der Kontaktschicht (6) zur Barriereschicht (5).

11. Verfahren zur Herstellung eines zur Strahlungserzeugung geeigneten optoelektronischen Halbleiterchips gemäß Anspruch 1, umfassend die Schritte:
- Bereitstellen eines Halbleiterkörpers (2), der eine Halbleiterschichtenfolge mit einer Barriereschicht (5) und einem zur Strahlungserzeugung geeigneten aktiven Bereich (3) aufweist,
- Ausbilden einer Zwischenschicht (20) auf der Barriereschicht (5),
- Ausbilden einer Anschlussschicht (4) auf der Zwischenschicht (20),
- Entfernen von Bereichen der Anschlussschicht (4) und der zwischenschicht (20) zur Herstellung einer strukturierten Anschlussschicht (4) und zwishenschicht (20),
- Aufbringen einer strahlungsdurchlässigen und elektrisch leitfähigen Kontaktschicht (6) auf den Halbleiterkörper derart, dass die Kontaktschicht (6) an die Anschlussschicht (4) angrenzt und in einem von einem Anschlussbereich (140) einer vorgesehenen Elektrode (14) überdeckten Bereich vollflächig an die Barriereschicht (5) angrenzt,
- Aufbringen der Elektrode (14) auf den Halbleiterkörper, wobei die Elektrode den Anschlussbereich (140) aufweist und die Elektrode auf der von der Barriereschicht (5) abgewandten Seite des aktiven Bereichs (3) angeordnet ist und wobei die Struktur der Anschlussschicht (4), der Zwischenschicht (20) und die Elektrode (14) derart aufeinander abgestimmt sind, dass die Anschlussschicht (4) und die Zwischenschicht (20) in einem von dem Anschlussbereich (140) der Elektrode überdeckten Bereich vollflächig ausgespart sind, wobei sich die Kontaktschicht (6) durch die Aussparung der Zwischenschicht (20) erstreckt.

12. Verfahren nach Anspruch 11, bei dem ein Halbleiterchip gemäß einem der Ansprüche 2 bis 10 hergestellt wird.

## Claims

1. Optoelectronic semiconductor chip (1) comprising a semiconductor body (2), which has a semiconductor layer sequence having an active region (3) suitable for radiation generation, comprising:
- a radiation-permeable and electrically conductive contact layer (6), which is arranged on the semiconductor body (2) and is electrically conductively connected to the active region (3), wherein the contact layer (6) adjoins a barrier layer (5) of the semiconductor layer sequence and a connection layer (4), which is applied on the semiconductor body (2) and has a structure;
- an electrode (14), which is arranged on a side of the active region (3) on the semiconductor body (2) which faces away from the barrier layer (5) and has a connection region (140), wherein the contact layer (6) adjoins, over the whole area, the barrier layer in a region of the barrier layer (5) which is overlapped by the connection region (140) of the electrode (14);
- an interlayer (20) of the semiconductor layer sequence between the connection layer (4) and the barrier layer (5), which interlayer has a structure and has a cutout in the region overlapped by the electrode, wherein the contact layer (6) extends through the cutout in the interlayer (20).

2. Semiconductor chip according to Claim 1, in which the connection layer (4) contains a radiation-permeable and electrically conductive oxide.

3. Semiconductor chip according to one of the preceding claims, in which the contact layer (6) contains a radiation-permeable and electrically conductive oxide, in particular a metal oxide, for example a zinc oxide, a tin oxide or an indium tin oxide.

4. Semiconductor chip according to one of the preceding claims, in which a mirror layer (9) is arranged on that side of the contact layer (6) which faces away from the active region (3).

5. Semiconductor chip according to Claim 4, in which the mirror layer (9) contains a metal, in particular Au, Ag or Al.

6. Semiconductor chip according to one of the preceding claims, in which the barrier layer (5) is arranged between the active region (3) and the connection layer (4).

7. Semiconductor chip according to one of the preceding claims, in which the semiconductor body (2) is in the form of a thin-film semiconductor body.

8. Semiconductor chip according to one of the preceding claims, in which the semiconductor chip (1) comprises a carrier (10), on which the semiconductor layer sequence (2) is arranged, and the contact layer (6) is arranged between the semiconductor layer sequence and the carrier (10).

9. Semiconductor chip according to Claims 4 and 8, in which the mirror layer is arranged between the contact layer and the carrier.

10. Semiconductor chip according to one of the preceding claims, in which an electrical contact resistance of the contact layer (6) with respect to the connection layer (4) is less than an electrical contact resistance of the contact layer (6) with respect to the barrier layer (5).

11. Method for producing an optoelectronic semiconductor chip according to Claim 1 suitable for radiation generation, said method comprising the following steps:
- providing a semiconductor body (2), which has a semiconductor layer sequence comprising a barrier layer (5) and an active region (3) suitable for radiation generation,
- forming an interlayer (20) on the barrier layer (5),
- forming a connection layer (4) on the interlayer (20),
- removing regions of the connection layer (4) and the interlayer (20) so as to produce a structured connection layer (4) and interlayer (20),
- applying a radiation-permeable and electrically conductive contact layer (6) to the semiconductor body in such a way that the contact layer (6) adjoins the connection layer (4) and adjoins the barrier layer (5) over the full area in a region overlapped by a connection region (140) of a provided electrode (14),
- applying the electrode (14) to the semiconductor body, wherein the electrode has the connection region (140) and the electrode is arranged on that side of the active region (3) which faces away from the barrier layer (5), and wherein the structure of the connection layer (4), of the interlayer (20) and the electrode (14) are matched to one another in such a way that the connection layer (4) and the interlayer (20) are cut out over the full area in a region overlapped by the connection region (140) of the electrode, wherein the contact layer (6) extends through the cutout in the interlayer (20).

12. Method according to Claim 11, in which a semiconductor chip according to one of Claims 2 to 10 is produced.

## Revendications

1. Puce de semi-conducteur optoélectronique (1) comportant un corps semi-conducteur (2), qui présente une succession de couches semi-conductrices avec une zone (3) active appropriée pour la génération de rayonnement, comprenant :
- une couche de contact (6) conductrice électriquement, disposée sur le corps semi-conducteur (2) est reliée de manière conductrice électriquement et perméable aux rayonnements avec la zone active (3), dans laquelle la couche de contact (6) est contiguë à une couche de barrière (5) de la succession de couches semi- conductrices et à une couche de raccord (4) appliquée sur le corps semi-conducteur (2) et présentant une structure ;
- une électrode (14) disposée sur le corps semi-conducteur (2) sur un côté de la zone active (3) qui se détourna de la couche barrière (5), qui présente une zone de raccord (140), dans laquelle la couche de contact (6) est contiguë sur toute la surface à la couche de barrière dans une zone de la couche de barrière (5) recouverte par la zone de raccord (140) de l'électrode (14) ;
- une couche intermédiaire (20) présentant une structure de la succession de couches semi-conductrices entre la couche de raccord (4) et la couche de barrière (5), qui présente un évidement dans la zone recouverte par l'électrode, dans lequel la couche de contact (6) s'étend à travers l'évidement de la couche intermédiaire (20).

2. Puce de semi-conducteur selon la revendication 1, dans laquelle la couche de raccord (4) contient un oxyde perméable au rayonnement et conducteur électriquement.

3. Puce de semi-conducteur selon une des revendications précédentes, dans laquelle la couche de contact (6) présente un oxyde perméable au rayonnement et électriquement conducteur, notamment un oxyde métallique, par exemple un oxyde de zinc, un oxyde d'étain ou un oxyde d'étain indium.

4. Puce de semi-conducteur selon une des revendications précédentes, dans laquelle sur le côté de la couche de contact (6) qui se détourne de la zone active (3) une couche miroir (9) est disposée.

5. Puce de semi-conducteur selon la revendication 4, dans laquelle la couche miroir (9) contient un métal, notamment Au, Ag ou Al.

6. Puce de semi-conducteur selon une des revendications précédentes, dans laquelle la couche de barrière (5) disposée entre la zone active (3) et la couche de raccord (4).

7. Puce de semi-conducteur selon une des revendications précédentes, dans laquelle le corps semi-conducteur (2) est conçu comme un corps semi-conducteur à couches minces.

8. Puce de semi-conducteur selon une des revendications précédentes, dans laquelle la puce de semi-conducteur (1) comprend un support (10), sur lequel la succession de couche semi-conductrices (2) est disposée et la couche de contact (6) est disposée entre la succession de couche semi-conductrices et le support (10).

9. Puce de semi-conducteur selon les revendications 4 et 8, sur laquelle la couche miroir est disposée entre la couche de contact et le support.

10. Puce de semi-conducteur selon une des revendications précédentes, sur laquelle une résistance de contact électrique de la couche de contact (6) par rapport à la couche de raccord (4) est plus petite qu'une résistance de contact électrique de la couche de contact (6) par rapport à la couche de barrière (5).

11. Procédé de fabrication une puce de semi-conducteur optoélectronique appropriée pour la génération de rayonnement selon la revendication 1, comprenant les étapes consistant à :
- fournir un corps semi-conducteur (2), qui présente une succession de couches semi conductrices avec une couche de barrière (5) et une zone active (3) appropriée pour la génération de rayonnement,
- réaliser une couche intermédiaire (20) sur la couche de barrière (5),
- réaliser une couche de raccord (4) sur la couche intermédiaire (20),
- éliminer des zones de la couche de raccord (4) et de la couche intermédiaire (20) pour produire une couche de raccord structurée (4) et une couche intermédiaire (20) struckturée,
- appliquer une couche de contact (6) perméable au rayonnement et conductrice électriquement sur le corps semi-conducteur de telle sorte que la couche de contact (6) soit contiguë à la couche de raccord (4) et soit contiguë sur toute la surface à la couche de barrière (5) dans une zone recouverte par une zone de raccord (140) d'une électrode prévue (14),
- appliquer l'électrode (14) sur le corps semi-conducteur, dans lequel l'électrode présente la zone de raccord (140) et l'électrode est disposée sur le côté de la zone active (3) qui se détourne la couche de barrière (5), et dans lequel la structure de la couche de raccord (4), de la couche intermédiaire (20) et l'électrode (14) sont harmonisées les unes aux autres de telle sorte que la couche de raccord (4) et la couche intermédiaire (20) sont évidées sur toute la surface dans une zone recouverte par la zone de raccord (140) de l'électrode, dans lequel la couche de contact (6) s'étend à travers l'évidement de la couche intermédiaire (20).

12. Procédé selon la revendication 11, dans lequel une puce de semi-conducteur est fabriquée selon une des revendications 2 à 10.
